# EUROPÄISCHE PATENTSCHRIFT

(11) **EP 0 929 428 B1**
(45) Veröffentlichungstag und Bekanntmachung des Hinweises auf die Patenterteilung: **16.08.2000**
(21) Anmeldenummer: 97910222.5
(22) Anmeldetag: 25.09.1997
(51) Int. Cl.: B60T 8/36

(54) **VENTILSTEUERGERÄT MIT DREIDIMENSIONALER LEITERPLATTE IN MID-TECHNIK**
VALVE CONTROL DEVICE WITH TRIDIMENSIONAL PRINTED BOARD IN MID TECHNOLOGY
APPAREIL DE REGULATION DE VANNE AVEC CARTE DE CIRCUITS TRIDIMENSIONNELLE REALISEE SELON LA TECHNIQUE DES DISPOSITIFS D'INTERCONNEXION MOULES

(30) Priorität: 30.09.1996 DE 19640261
(43) Veröffentlichungstag der Anmeldung: 21.07.1999
(73) Patentinhaber: TYCO Electronics Logistics AG, 9323 Steinach (CH)
(72) Erfinder: HOFFELDER, Bernd, D-67354 Römerberg (DE)
(74) Vertreter: Heinz-Schäfer, Marion
(86) Internationale Anmeldenummer: DE9702183
(87) Internationale Veröffentlichungsnummer: WO9814357

(56) Entgegenhaltungen:
- EP-A- 0 373 551
- EP-A- 0 647 089
- WO-A-95/21758
- DE-A- 3 501 711
- DE-A- 4 225 358
- DE-A- 4 232 205
- US-A- 5 482 362

## Beschreibung

Die Erfindung betrifft ein Gerät zum Steuern von elektromagnetisch betätigten Ventilen für eine Druckflüssigkeit mit einem Gehäuse, in dem mindestens eine Ventilspule angeordnet und durch ein Fixiermaterial positioniert ist, mit mindestens zwei Steckerteilen mit Anschlußstiften, und mit einem Schaltungsträger, der mit jeder Ventilspule und mit jedem Steckerteil elektrisch verbunden ist.

Ein derartiges Ventilsteuergerät ist beispielsweise aus der DE 42 32 205 C2 bekannt. Das Gerät ist insbesondere als Steuergerät für ein Antiblockiersystem (ABS) in einem Kraftfahrzeug einsetzbar, bei dem die die Radbremsen betätigende Bremsflüssigkeit mit zwei Ventilen pro Rad gesteuert wird. Die Ventile werden je durch einen Elektromagneten betätigt.

Das aus der oben genannten Patentschrift bekannte ABS-System weist ein Gehäuse mit einem Gehäuserahmen und einem Deckel auf. Im Inneren des Gehäuses ist ein Schaltungsträger angeordnet, der auf einer Aluminiumgrundplatte befestigt ist, beispielsweise durch Kleben. Der Gehäuserahmen weist zwei einstückig mit ihm zusammen hergestellte Steckerteile auf, von denen das erste senkrecht zu einer Seitenfläche und das zweite schräg zur unteren Hauptfläche des Gehäuserahmens ausgerichtet ist. Die Steckerstifte, die durch zusätzliche mechanische Einzelteile gegeben sind, werden genauso wie die Anschlußdrähte der Ventilspulen bei der Montage des Ventilsteuergeräts elektrisch mit dem Schaltungsträger verbunden, indem die Steckerstifte und die Anschlußdrähte durch Bohrungen des Schaltungsträgers gesteckt und gelötet werden.

Der Aufbau des bekannten Geräts ist durch das komplexe räumliche Zusammenspiel vieler einzelner unterschiedlicher Komponenten (Leiterplatte, Steckerteile, Steckerstifte, elektronische Bauelemente, Ventilspulen) und durch die Lötvorgänge aufwendig. Ein konventioneller Schaltungsträger, beispielsweise eine Leiterplatte, ist aufgrund seiner Beschränkung auf eine Ebene im Grunde nicht optimal geeignet für den wesentlich dreidimensionalen Aufbau eines ABS-Moduls. Auch die Verwendung eines durch entsprechendes Ausformen und anschließendem Biegen dreidimensionalen Stanzgitters (Leadframe) führt insofern nicht weiter, als dieses fertigungstechnisch nur mit großem Aufwand herstellbar ist.

Andererseits steht heute mit den MIDs (Moulded Interconnect Devices), also mit dreidimensionalen Leiterplatten, eine neue Technik mit größerer, insbesondere räumlicher Gestaltungsfreiheit zur Verfügung. Dabei wird, meistens mittels Zweischußspritzgußtechnik ein Verbundkörper aus verschiedenen Kunststoffen erzeugt, von denen einer metallisierbar sein muß und der andere nicht. Das Schaltungslayout wird demnach durch die Formgebung der Spritzgußwerkzeuge in der Weise erzeugt, daß der Verbundkörper eine selektiv metallisierbare (durch Ätzen und Galvanisieren) Oberfläche erhält. Auch diese Fertigungstechnologie bedingt jedoch relativ hohe Werkzeugkosten, so daß ein verringerter Aufwand für das herzustellende Modul im allgemeinen nur resultiert, wenn es gelingt, die Zahl der Komponenten tatsächlich erheblich zu reduzieren. Dies ist vor allem dann nicht ohne weiteres möglich, wenn örtlich im Gerät gebundene Komponenten, hier die Ventilspulen und Steckerteile, vorhanden sind, die sich auch in der neuen Lösung in MID-Technik am gleichen Platz befinden müssen.

Der Erfindung liegt die Aufgabe zugrunde, ein weniger aufwendig herstellbares Ventilsteuergerät der eingangs genannten Art zu schaffen.

Diese Aufgabe wird erfindungsgemäß bei einem Ventilsteuergerät der eingangs genannten Art dadurch gelöst, daß der Schaltungsträger als dreidimensionale Leiterplatte in MID-Technik ausgebildet ist, daß die Steckerteile und auch die zugehörigen Anschlußstifte einstückig mit der Leiterplatte in MID-Technik ausgebildet sind, wobei sich von jeder der beiden Hauptflächen der Leiterplatte jeweils mindestens ein Steckerteil senkrecht wegerstreckt, und daß die Anschlüsse jeder Ventilspule als Einpreßkontakte und die zugehörigen Kontaktstellen der Leiterplatte als in MID-Technik metallisierte Durchgangslöcher ausgebildet sind.

Eine vorteilhafte Weiterbildung der Erfindung ergibt sich aus dem Unteranspruch.

Ein Ausführungsbeispiel der Erfindung ist nachfolgend unter Bezugnahme auf die schematische Zeichnung näher beschrieben. Es zeigen:
- Figur 1: einen Schnitt durch ein fertig montiertes Ventilsteuergerät
- Figur 2: eine seitliche Ansicht einer dreidimensionalen Leiterplatte für das Gerät gemäß Figur 1,
- Figur 3: einen Schnitt durch eine Leiterplatte gemäß Figur 2,
- Figur 4: einen anderen Schnitt durch ein Detail gemäß Figur 2,
- Figur 5: einen anderen Schnitt durch ein Gerät gemäß Figur 1,
- Figur 6 und 7,: jeweils in Draufsicht, die Ober- bzw. Unterseite der Leiterplatte gemäß Figur 2.

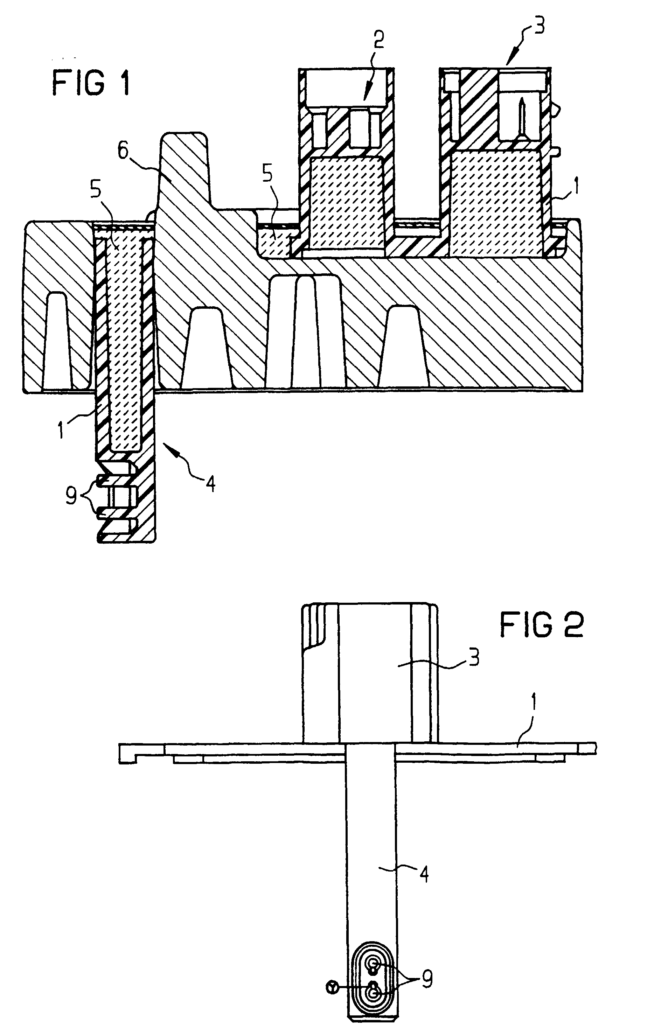

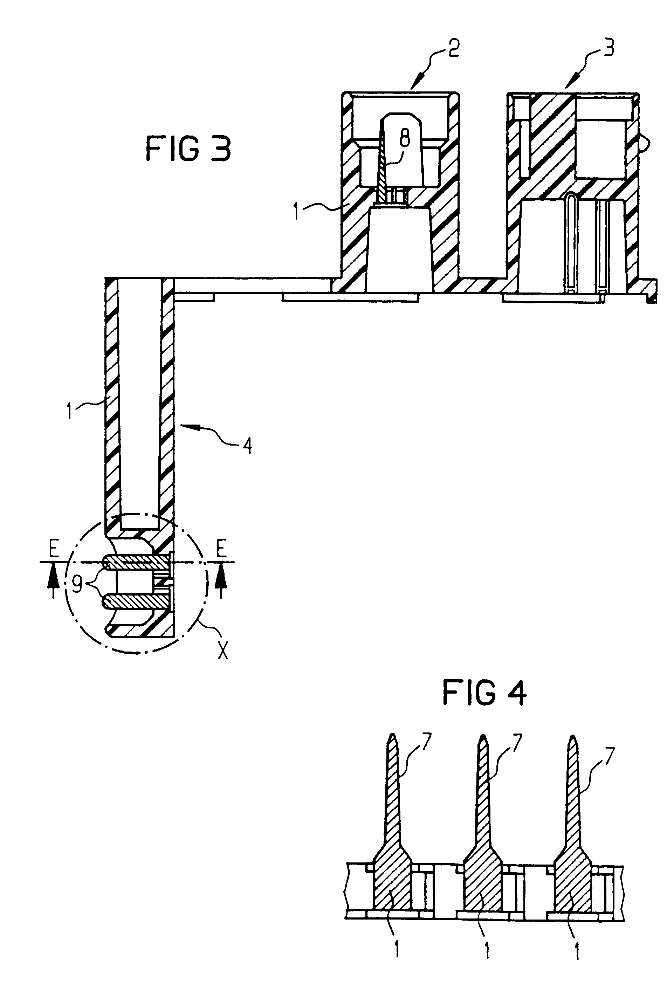

In Figur 1 ist die MID-Leiterplatte 1 erkennbar, auf deren Oberseite ein Massestecker 2 und ein zwölfpoliger Stecker 3 und auf deren Unterseite ein dritter, sich relativ weit nach unten erstreckender Stecker 4 integriert sind. Der Aufbau und die Geometrie der eigentlichen dreidimensionalen Leiterplatte 1 geht am besten aus den Figuren 2 beziehungsweise 3 hervor. Auch die Steckerstifte 7, 8 und 9 der drei dargestellten Stecker, wobei die Steckerstifte 7 des Steckers 3 in Figur 4 gesondert dargestellt sind, sind durch entsprechende Formung des Spritzgußwerkzeugs und durch die selektive galvanische Metallisierung integraler Bestandteil der MID-Leiterplatte 1. Da die nichtmtetallisierten Teile überwiegen, ist es günstig, diese mit dem ersten Schuß zu spritzen.

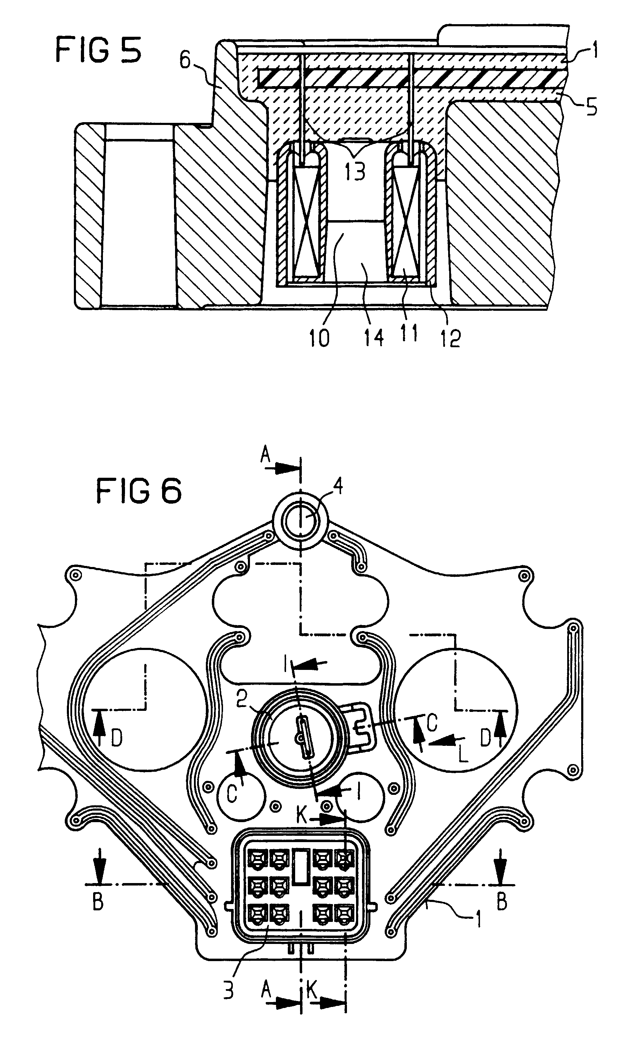

Zur Montage des Ventilsteuergeräts werden die üblicherweise acht Ventilspulen 10 pro Ventilblock, die jeweils einen bewickelten Spulenkörper 11 und einen Jochring 12 umfassen, vergleiche Figur 5, auf eine Festhaltevorrichtung gesetzt. Es wird ein Druckgußdeckel 6, beispielsweise aus Aluminium, aufgesetzt, die MID-Leiterplatte 1 wird auf den Druckgußdeckel 6 gesetzt und abwärts gepreßt, so daß die Einpreßanschlüsse 13 jeder Ventilspule 10 in den vorgesehenen metallisierten Durchgangslöchern der Leiterplatte 1 eingepreßt werden. Anschließend wird das Gerät mit einer elastischen Vergußmasse 5, beispielsweise einem Elastomer, umspritzt, um einen Schutz gegen Umwelteinflüsse, insbesondere Feuchtigkeit, zu erreichen. Als Fixiermaterial könnte aber zum Beispiel auch ein Kleber verwendet werden. Allerdings wird eine domartige Aussparung 14 in den Ventilspulen 10 beim Spritzvorgang freigehalten, in die später die elektromechanisch zu bewegenden Anker der Ventile gesteckt werden. Das Ventilsteuergerät ist letztlich dafür vorgesehen, auf einen in der Zeichnung nicht dargestellten Ventilblock, in dem die eigentlichen Ventile angeordnet sind, aufgesteckt zu werden. Die Ventilspulen 10 müssen im Ventilsteuergerät entsprechend der Geometrie dieses Ventilblocks angeordnet sein.

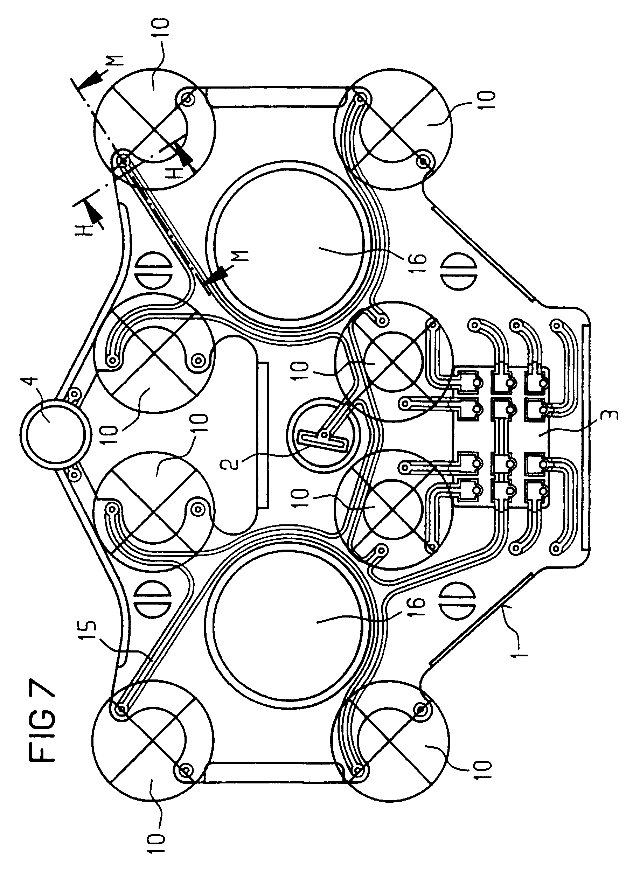

In den Figuren 6 und 7 ist erkennbar, daß bei allen Ventilspulen 10 von den zu den zugehörigen zwei metallisierten Durchgangslöchern führenden Leiterbahnen 15 jeweils eine auf jede Hauptfläche der Leiterplatte 1 verläuft. Diese Trennung verringert die Kurzschlußgefahr. Wie in Figur 7 erkennbar, sind die Leiterbahnen 15 auf der Unterseite der Leiterplatte 1 alle mit dem Massestecker 2 verbunden. Erkennbar in Figur 7 sind auch Aussparungen 16, in die Teile des Druckgußdeckels 6 eingreifen.

Auch die Kontaktierung der Steckerstifte 9 des länglichen Steckers 4, die parallel zur Leiterplatte 1 orientiert sind, erfolgt in MID-Technik. Die entsprechenden Leiterbahnen werden im Inneren des Steckers 4, das im übrigen auch mit Vergußmasse 5 gefüllt wird, nach unten bis zu den Steckerstiften 9 geführt.

Als Steckerstifte werden insbesondere für den zwölfpoligen Stecker 3 flache, z.B. 0,63mm dicke Zungen aus leitendem Kunststoff für sogenannte Fasten-Stecker gespritzt. Für die Einpreßkontakte der Ventilspulen werden die aus der Kommunikationstechnik an sich bekannten H-Shape-Stifte, oder Einpreßstifte anderer Form, benutzt. Die Einpreßkontakte können gegebenenfalls aus Sicherheitsgründen noch zusätzlich gelötet werden.

Durch die integrierte dreidimensionalen Leiterplatte 1, bei der die vollständigen Stecker im Spritzvorgang gleich mit realisiert werden, entfällt das dreidimensionale Stanzgitter, es entfallen die zusätzlichen mechanischen Steckerstifte und es entfallen die verschiedenen Lötvorgänge der Anschlüsse der Spulen und Stecker. Der Fertigungsaufwand verringert sich dadurch insgesamt etwa auf die Hälfte des bei konventioneller Technik erforderlichen Aufwandes.

## Patentansprüche

1. Gerät zum Steuern von elektromagnetisch betätigten Ventilen für eine Druckflüssigkeit mit
- einem Gehäuse, in dem mindestens eine Ventilspule (10) angeordnet und durch ein Fixiermaterial (5) positioniert ist,
- mindestens zwei Steckerteilen (2, 3, 4) mit Anschlußstiften (7, 8, 9),
- einem Schaltungsträger, der mit jeder Ventilspule (10) und mit jedem Steckerteil (2, 3, 4) elektrisch verbunden ist,
**dadurch gekennzeichnet,** daß
- der Schaltungsträger als dreidimensionale Leiterplatte (1) in MID-Technik ausgebildet ist,
- die Steckerteile (2, 3, 4) und auch die zugehörigen Anschlußstifte (7, 8, 9) einstückig mit der Leiterplatte (1) in MID-Technik ausgebildet sind, wobei sich von jeder der beiden Hauptflächen der Leiterplatte (1) jeweils mindestens ein Steckerteil (3, 4) senkrecht wegerstreckt,
- die Anschlüsse jeder Ventilspule (10) als Einpreßkontakte (13) und die zugehörigen Kontaktstellen der Leiterplatte (1) als in MID-Technik metallisierte Durchgangslöcher ausgebildet sind.

2. Gerät nach Anspruch 1,
**dadurch gekennzeichnet,**
daß bei mindestens einer der Ventilspulen (10) von den zu den zugehörigen zwei metallisierten Durchgangslöchern führenden Leiterbahnen (15) jeweils eine auf jeder Hauptfläche der Leiterplatte (1) verläuft.

## Claims

1. Appliance for controlling electromagnetically actuated valves for a hydraulic fluid, having
- a housing which contains at least one valve coil (10) positioned by means of a fixing material (5),
- at least two connector parts (2,3,4) with connection pins (7,8,9),
- a circuit carrier which is electrically connected to each valve coil (10) and to each connector part (2,3,4),
characterized in that,
- the circuit carrier is designed as a three-dimensional printed circuit board (1) using MID technology,
- the connector parts (2,3,4) and also the associated connection pins (7,8,9) are designed to be integral with the printed circuit board (1) using MID technology, with at least one connector part (3,4) in each case extending away perpendicularly from each of the two main surfaces of the printed circuit board (1),
- the connections of each valve coil (10) are designed as push-in contacts (13) and the associated contact points on the printed circuit board (1) are designed as through holes metallized using MID technology.

2. Appliance according to Claim 1, characterized in that, in the case of at least one of the valve coils (10), a respective one of the conductor tracks (15) leading to the associated two metallized through holes runs on each main surface of the printed circuit board (1) .

## Revendications

1. Appareil de régulation de soupapes actionnées électromagnétiquement pour un fluide sous pression comprenant :
- un boîtier, dans lequel au moins une bobine de soupape (10) est disposée et est positionnée par une matière de fixation (5),
- au moins deux parties de fiches (2, 3, 4) avec des broches de sortie (7, 8, 9),
- un support de circuits, qui est relié électriquement à chaque bobine de soupape (10) et à chaque partie de prise (2, 3, 4),
caractérisé en ce que
- le support de circuits est conçu comme une carte imprimée tridimensionnelle (1) dans la technique des dispositifs d'interconnexion moulés,
- les parties de fiche (2, 3, 4) et également les broches de sortie (7, 8, 9) en faisant partie sont conçues en une seule pièce avec la carte imprimée (1) dans la technique des dispositifs d'interconnexion moulés, à chaque fois au moins une partie de broche (3, 4) s'étendant à distance perpendiculairement de chacune des deux surfaces principales de la carte imprimée (1),
- les connexions de chaque bobine de soupape (10) sont conçues comme des contacts à encastrer (13) et les endroits de contact en faisant partie de la carte imprimée (1) sont conçus comme des trous de passage métallisés dans la technique des dispositifs d'interconnexion moulés.

2. Appareil selon la revendication 1, caractérisé en ce que dans au moins l'une des bobines de soupape (10) des pistes conductives (15) conduisant aux deux trous de passage métallisés en faisant partie, à chaque fois une passe sur chaque surface principale de la carte imprimée (1).
